Europäisches Patentamt

European Patent Office

Office européen des brevets

(19)

(11) Publication number: 0 401 587
A2

# EUROPEAN PATENT APPLICATION

(12)

(21) Application number: 90109645.3

(22) Date of filing: 21.05.90

(51) Int. Cl.5: H03K · 17/13

(30) Priority: 05.06.89 US 361071

(43) Date of publication of application:
12.12.90 Bulletin 90/50

(84) Designated Contracting States:
DE FR GB IT

(71) Applicant: MOTOROLA, INC.
1303 East Algonquin Road
Schaumburg, IL 60196(US)

(72) Inventor: Pirastehfar, Hassan
3720 E Menlo
Mesa, Arizona 85215(US)
Inventor: Clark, Lowell E.
5901 E Calle Del Sud
Phoenix, Arizona 85018(US)

(74) Representative: Holt, Michael et al
MOTOROLA European Intellectual Property
Operations Jays Close Viables Industrial
Estate
Basingstoke Hampshire RG22 4PD(GB)

(54) Monolithic zero crossing triac driver.

(57) A monolithic zero crossing triac driver is pro-
vided that includes a resistor network (21,22,21',22')
coupled between two AC terminals (13,14) which
provides a leakage current to the gate of a shunting
field effect transistor (16), thereby ensuring the
shunting transistor (16) is fully turned on when there
is an AC voltage on the terminals (13,14), regardless
of whether or not a light signal is applied to the
circuit. The resistor network (21,22,21',22') is formed
on the surface of the monolithic triac driver by
depositing a high resistivity film over metal intercon-
nections which are formed on the surface of the triac
driver.

*FIG. 2*

## MONOLITHIC ZERO CROSSING TRIAC DRIVER

### Background of the Invention

This invention relates, in general, to switching circuits and, more particularly, to an optically triggered thyristor which is triggerable only near the zero crossing point.

Triac drivers are monolithic devices designed for use with an external triac in the interface of logic systems to equipment powered from high voltage AC lines, such as solid state relays, industrial controls, motors, solenoids, and consumer appliances. A triac driver is itself a triac, or thyristors connected in inverse parallel, and may be triggered by either a single gate terminal or by the application of light. A triac driver is placed in series with the gate of the external triac, and couples current from the high voltage line to trigger the gate of the external triac.

To isolate the logic systems from the high voltage AC lines, triac drivers are often optically triggered by providing an LED or similar device in the same package as the triac driver. In these devices, a light signal is used to trigger the thyristors by generating a bias current in a junction of the thyristors. This optically generated bias current will latch the thyristors on, thus providing a trigger current to the external triac.

Triggering the external triac at high values of main terminal voltage is generally undesirable because of the generation of noise, and the possibility of premature device failure because of highly localized current density within the device itself. To avoid these problems while switching an AC voltage it is desirable to trigger the triac as near as possible to the zero crossing point of the AC voltage. Zero crossing triac driver circuits comprise a zero crossing circuit which shorts out the optically generated bias current of the thyristor when the AC main terminal voltage is outside of a predetermined window. When the zero crossing circuit is formed on the same chip as the thyristors, however, it is itself sensitive to optically generated currents when a light signal is present. In the past it has been difficult to achieve proper function of the zero crossing circuit in both illuminated and dark conditions.

One zero crossing circuit is shown in U.S. Patent No. 4,458,408 issued to Alonas et al. The Alonas patent shows a field effect transistor coupled so as to short out the gate of the thyristor, the field effect transistor having a gate which is coupled to the AC main terminal voltage. The threshold voltage of the field effect transistor is designed so that when the AC main terminal voltage is outside of the predetermined window the field effect transistor is turned on thus shunting current from the thyristor and ensuring that the thyristor remains in an off state, even when illuminated. This zero crossing circuit required the gate of the field effect transistor to withstand the peak value of the AC voltage, which is commonly several hundred volts. This required thick gate oxides which in turn limited control over the threshold voltage and resulted in a large window of voltages above and below the zero crossing point at which the thyristor would trigger, and a large variability in the size of the trigger window. Also, since a gate electrode of the shunting field effect transistor was coupled to high voltage it could not overlay other devices on the chip, thus the gate of the field effect transistor had to be coupled to the AC terminal voltage by a wire bond, which increased complexity of the device.

Another zero crossing circuit which has been used in the past is a modified version of the Alonas circuit. In this circuit a high voltage photodiode was coupled between one of the AC terminals and the gate of the field effect transistor and a zener diode was coupled between the gate and the other AC terminal. Using this circuit the voltage on the gate of the field effect transistor could be maintained in the range of 10-20 volts so that a thin gate oxide could be used. This circuit allowed improved control over the threshold voltage of the field effect transistor and thus provided a smaller, less variable, window around the zero point at which the thyristor would trigger. Also, since the gate electrode of the field effect transistor was not connected to high voltage, the gate wire bond was eliminated. This circuit relied on leakage current through the photodiode to charge the gate input capacitance of the shunting field effect transistor when the AC main terminal voltage was outside of the predetermined window. While the photodiode leakage current was sufficient when the diode was illuminated, in order to provide sufficient leakage current in the dark state a large area diode was required. Also, because leakage current in the photodiode was difficult to control, the shunting field effect transistor occasionally could not be turned on, resulting a sensitivity to noise on the AC main terminal when the device was in a dark state..

Accordingly it is an object of the present invention to provide a triac driver having an improved zero crossing effect.

Another object of the present invention is to provide a triac driver with improved reliability.

Still another object of the present invention is to provide a triac driver with more predictable performance in the dark state.

## Summary of the Invention

These and other objects and advantages of the present invention are achieved by providing a triac driver having a resistor network coupled between two AC terminals which provides a leakage current to the gate of a shunting field effect transistor, thereby ensuring the shunting transistor is fully turned on when there is an AC voltage on the terminals, regardless of whether or not a light signal is applied to the circuit.

## Brief Description of the Drawings

FIG. 1 is a schematic of a prior art zero crossing triac driver; and
FIG. 2 is a schematic of the preferred embodiment of the present invention.

## Detailed Description of the Drawings

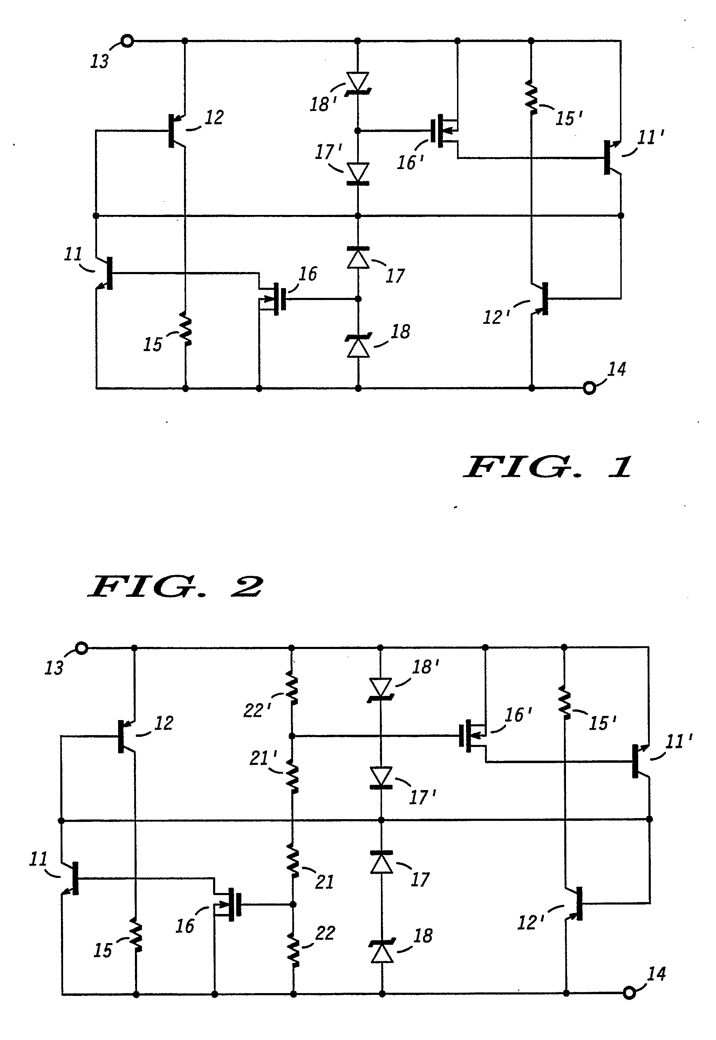

FIG. 1 illustrates a schematic of a prior art zero crossing triac driver described in the background of the invention. Transistor 11 with transistor 12 and transistor 11′ together with transistor 12′ respectively formed two thyristors in the back-to-back or inverse parallel configuration. It should be understood that the thyristors may each be a single PNPN device, but are represented by two transistors, each having a collector, a base and an emitter, for ease of description. Only the connections and operation for the thyristor including transistors 11 and 12 will be described herein; however, the other thyristor bearing the prime designations will be connected and operated in a similar fashion.

The collector and base of transistor 11 are connected to the base and collector of transistor 12 respectively. The emitter of transistor 12, which is also the anode of the thyristor formed by transistors 11 and 12, is connected to main terminal 13. The emitter of transistor 11, which is also the cathode of the thyristor, is connected to main terminal 14. The base of transistor 11 forms the gate of the thyristor. Resistor 15 is coupled between the base of transistor 11 and main terminal 14 for shunting transistor 11 in order to reduce the sensitivity of the thyristor and preclude triggering by unwanted signals. Field effect transistor 16 has its drain connected to both the base of transistor 11 and the collector of transistor 12, and its source connected to main terminal 14 for shunting the base to emitter junction of transistor 11. The gate of field effect transistor 16 is coupled to the anode of photodiode 17 and the cathode of zener diode 18. The cathode of photodiode 17 is coupled to both the collector of transistor 11 and the base of transistor 12. The anode of zener diode 18 is coupled to main terminal 14. Field effect transistor 16 is preferably an enhancement type field effect transistor which does not conduct when the voltage across the gate to source is below a predetermined threshold voltage. The breakdown voltage of zener diode 18 is chosen to be higher that the threshold voltage of field effect transistor 16, and the blocking voltage of photodiode 17 is chosen to be as high as the blocking voltage of the switching thyristor.

When the circuit is illuminated and the AC voltage on main terminals 13 and 14 is high, the leakage current of photodiode 17 will charge the internal gate capacitance of field effect transistor 16. A biasing current which is optically generated in the base emitter junction of transistor 11 is thus shunted through field effect transistor 16 so that transistor 11 remains in an off state. As long as the voltage on main terminals 13 and 14 is higher than the breakdown voltage of zener diode 18, the gate of field effect transistor 16 is charged to the zener breakdown voltage.

When the circuit is in a light condition and the AC voltage on main terminal 13 and 14 falls below the breakdown voltage of zener diode 18, photodiode 17 becomes forward biased and discharges the gate capacitance of field effect transistor 16. When the voltage on main terminals 13 an 14 falls below the threshold voltage of field effect transistor 16, transistor 16 will turn off. In this state the optically generated biasing current of transistor 11 serves to activate transistor 11 and transistor 12, thus latching the thyristor on.

A significant portion of the leakage current through photodiode 17 when the AC voltage on main terminal 13 and 14 is high is due to optically generated charge carriers in the diode. In the dark state insufficient leakage current flows through diode 17 to keep field effect transistor 16 turned on even when the voltage on main terminals 13 and 14 is several hundred volts. Thus, if a voltage spike occurs on main terminals 13 and 14 in the dark state, while field effect transistor 16 is off, the thyristor comprising transistors 11 and 12 can inadvertently be turned on, and latch on, while no activating signal is present.

FIG. 2 illustrates a schematic of a the preferred embodiment of the present invention. Elements 11-18 of FIG. 2 correspond to elements 11-18 of FIG. 11 and function in the same manner as described in reference to FIG. 11. A resistor network comprising resistors 21, 22 and 21′, 22′ is formed between the two main terminals 13 and 14. The resistor network serves only as a leakage path to couple charge from the main terminals 13 and 14 to the gate of transistors 16 and 16' so the exact value of the resistors is not important. Of course, a lower value of resistors allows more charge to flow between the main terminals and increases power loss in the circuit. One end of resistor 21 is coupled to the collector of transistor 11 and the base of transistor 12, and the other end of resistor 21 is coupled to the gate of field effect transistor 16. One end of resistor 22 is coupled to the gate of field effect transistor 16, and the other end of resistor 22 is coupled to main terminal 14. In this manner a voltage divider is set up which will provide current to the gate of field effect transistor 16 as long as the voltage on main terminals 13 and 14 is high. The current thus provided will be present in both the light and dark conditions. Zener diode 18 serves to clamp the voltage between the gate and source of field effect transistor 16 regardless of the values of resistors 21 and 22. Preferably resistors 21 and 22 are formed of a high resistivity film and the resistor values for each of the resistors is in the order of 1 to 2 Megaohm. It is been found that charge coupled to the gate of field effect transistor 16 by resistors of this magnitude is sufficient to guarantee that field effect transistor 16 is in the on condition whenever a high voltage is present between main terminals 13 and 14.

In a preferred embodiment the circuit shown in FIG. 2 is formed monolithically on a semiconductor substrate. The interconnection from the gate of field effect transistor 16 to the blocking diode and the zener diode is formed by a patterned metal layer formed on the surface of the device. Resistors 21 and 22 then can be formed by applying a high resistivity amorphous silicon film covering the patterned metal layer, thereby forming resistors between discontinuous areas in the patterned metal layer. Resistors formed in this manner will be on the order of 1-2 Megaohms and have a wide distribution of actual values, but the ratio of resistor 21 to resistor 22 will remain fixed by the geometry of the discontinuities in the metal layer. The amorphous silicon film serves to create a controlled leakage path between main terminals 13, 14 and the gate of field effect transistor 16 as described hereinbefore.

Amorphous silicon is commonly used as a passivation material on top of patterned metal layers. Properties of amorphous silicon such as mechanical strength and chemical resistance are well known. Amorphous silicon film are also used as field plates to stabilize and improve junction breakdown of semiconductor diodes. In the preferred embodiment, the amorphous silicon film replaces a passivation layer, so that no additional processing steps are required to form resistors 21 and 22.

It should be now apparent that an improved zero crossing triac driver has been provided comprising a field effect transistor which is coupled to shunt the gate of an optically triggerable thyristor. The gate of the field effect transistor is coupled to a high value resistor formed between the main terminals of the triac driver. In this manner a voltage divider is formed so that the gate of the field effect transistor can be maintained in an on state when the voltage on the main terminals is high, regardless of whether or not the device is illuminated.

## Claims

1. A light operated zero-crossing switch having a first terminal (13) and a second terminal (14) coupled for receiving an AC voltage, a gated light sensitive switching means (11) coupled between the two terminals for controllably switching current between the terminals when a light signal is received, and a control means (16) coupled to the gate of the light sensitive switching means (11) for disabling the switching means (11) when a control signal is present, the improvement comprising a resistor network (21,22,21',22') coupled between the two terminals (13,14) used for providing the control signal to the control means (16).

2. The zero-crossing switch of claim 1 wherein the control means (16) comprises a field effect transistor having a drain coupled to the gate of the switching means (11), a source coupled to one of the terminals (14), and a gate coupled to the resistor network (21,22); and a zener diode (18) having a cathode coupled the gate of the field effect transistor (16) and an anode coupled to the source of the field effect transistor (16).

3. The zero-crossing switch of claim 1 wherein the resistor network comprises four resistors (21,22,21',22') coupled in series having a first node coupled to one terminal (13), a second node connected to the other terminal (14), and a third node coupled to the control means (16).

4. The zero-crossing switch of claim 1 wherein the resistor network (21,22) is formed of amorphous silicon.

5. A monolithic light operated zero-crossing switch having a first terminal (13) and a second terminal (14) coupled for receiving an AC voltage, comprising: a light sensitive thyristor (11,12) having an anode coupled to the first terminal (14), a cathode coupled to the second terminal (13), and having a gate; a field effect transistor (16) having a gate, and current carrying electrodes coupled between the gate of the thyristor (11,12) and the cathode of the thyristor (11,12); and a resistor (21,22,21',22') coupled between the two terminals (13,14), the resistor being tapped between the two terminals (13,14) to provide current to the gate of the field effect transistor (16).

6. The zero-crossing switch of claim 5 further comprising a zener diode (18) having a cathode coupled to the gate of the field effect transistor (16) and an anode coupled to the second terminal (14).

7. The zero-crossing switch of claim 5 or 6 wherein the switch further comprises a diode (17) having a cathode coupled to the gate of the thyristor (11,12), and an anode coupled to the gate of the field effect transistor (16).

8. The zero-crossing switch of claim 5 wherein the resistor (21,22,21',22') is formed of amorphous silicon.

9. A method for providing a control current to a zero crossing circuit of a monolithic light activated zero-crossing switch having a top surface, the method comprising the steps of: forming a metal layer on the top surface; patterning the metal layer so that the pattern is discontinuous in selected areas; and forming a high resistivity film coupling the discontinuous areas, and coupled to a power supply voltage, wherein the control current flows from the power supply to the zero crossing circuit through the high resistivity film.

10. The method of claim 9 wherein the high resistivity film comprises amorphous silicon.

FIG. 1

FIG. 2